# EUROPÄISCHE PATENTSCHRIFT

(11) **EP 2 225 125 B1**
(45) Veröffentlichungstag und Bekanntmachung des Hinweises auf die Patenterteilung: **03.05.2017**
(21) Anmeldenummer: 08860911.0
(22) Anmeldetag: 27.11.2008
(51) Int. Cl.: H05K 7/20, H05K 5/00

(54) **STEUERGERÄTEGEHÄUSE**
CONTROLLER HOUSING
CARTER D'APPAREIL DE COMMANDE

(30) Priorität: 19.12.2007 DE 102007061116
(43) Veröffentlichungstag der Anmeldung: 08.09.2010
(73) Patentinhaber: Robert Bosch GmbH, 70442 Stuttgart (DE)
(72) Erfinder: WETZEL, Gerhard, 70825 Korntal-Muenchingen (DE); DERINGER, Helmut, 74391 Erligheim (DE); TRESCHER, Ulrich, 72072 Tuebingen (DE); SIEMS, Hans-Dieter, 71735 Eberdingen (DE); SCHAEFER, Eckhard, 72074 Tuebingen (DE)
(86) Internationale Anmeldenummer: PCT/EP2008/066283
(87) Internationale Veröffentlichungsnummer: WO 2009/077300

(56) Entgegenhaltungen:
- EP-A- 1 841 303
- DE-A1- 10 340 974
- DE-A1- 19 640 466
- DE-A1-102005 063 280

## Beschreibung

### Stand der Technik

Bei Getriebesteuerungsmodulen für Getriebe von Kraftfahrzeugen kommen heute Hybridsteuergeräte, Sensoren und mindestens eine Steckverbindung für den Anschluss des Getriebesteuerungsmoduls an einen Fahrzeugkabelbaum eines Kraftfahrzeuges zum Einsatz. Die Steckverbindung zum Anschluss an den Kabelbaum eines Kraftfahrzeuges wird auch als Getriebestecker bezeichnet. Die besagten Getriebesteuerungsmodule werden zur Zeit unter Verwendung von ATF (automatic transmission fluid) eingesetzt und sind sehr hohen Temperaturschwankungen von einer Temperatur von -40 °C bis 150 °C im Fahrzeuggetriebe ausgesetzt. Um die im Getriebesteuerungsmodul eingesetzte, empfindliche Elektronik vor dem aggressiven Getriebefluid (ATF = automatic transmission fluid) zu schützen, wird angestrebt, die Elektronik in einem dichten Gehäuse unterzubringen. Um bei den erwähnten hohen Betriebstemperaturen eine ausreichende Wärmeabfuhr für die elektronischen Bauelemente des Getriebesteuerungsmoduls zu gewährleisten, wird die metallische Grundfläche des Steuergerätegehäuses des Getriebesteuerungsmoduls an das Aluminiumgehäuse einer Getriebehydraulik angestellt. Dies bedeutet, dass die metallische Grundfläche des Steuergerätegehäuses das Aluminiumgehäuse der Getriebehydraulik kontaktiert, wodurch eine Wärmeabfuhr der Verlustwärme durch Wärmeleitung erfolgt.

Eine in Serie befindliche Ausführungsform eines Getriebesteuerungsmoduls enthält ein hermetisch dichtes Steuergerätegehäuse für eine elektronische Schaltung. Das hermetisch dichte Steuergerätegehäuse selbst besteht aus einer eben ausgebildeten Stahlgrundplatte mit eingeglasten Metallstiften, welche die elektrische Kontaktierung zwischen Schaltung und Stanzgitter mittels Bonden ermöglichen, und einem Stahldeckel, der dicht mit der Grundplatte verschweißt ist. Die elektrische Verbindung vom eingeglasten Metallstift zu den Sensoren und Steckern des Elektronikmoduls erfolgt über Stanzgitter. Die Stanzgitter sind an die eingeglasten Stifte angeschweißt. Da die eingeglasten Stifte senkrecht aus der Grundplatte des Steuergerätes herausragen, besteht die Notwendigkeit, dass die für die Wärmeableitung notwendige Kontaktfläche der Getriebehydraulik eine erhöhte Fläche bildet.

DE 196 40 466 B4 offenbart ein metallisches Trägerteil für elektronische Bauelemente oder Schaltungsträger sowie ein Verfahren zur Herstellung desselben. In DE 196 40 466 B4 wird ein hermetisch dichtes Gehäuse beschrieben, in welchem die eingeglasten Metallstifte (Pins) nicht direkt in das Bodenteil des Steuergerätegehäuses eingeglast sind, sondern in zwei separate Teile. Die beiden separaten Teile werden auch als Stiftleisten bezeichnet, die nach deren Herstellung in die Bodenplatte eingeschweißt werden. Diese Technik hat den Vorteil, dass nur die kleinen Stiftleisten beim Einglasen erhitzt werden müssen, die große Bodenplatte jedoch nicht den hohen Temperaturen, die beim Einglasen auftreten, ausgesetzt werden muss.

Eine weitere derzeit in Serie befindliche Ausführungsform eines Elektronikmoduls mit abgedichtetem Steuergerätegehäuse wird auf Basis einer auf einer Aluminiumplatte aufgeklebten flexiblen Leiterplatte (FPC = flexible printed circuit) bereitgestellt. DE 199 07 949 A1 beschreibt die Funktion des dichten Steuergerätegehäuses. Eine flexible Leiterplatte, die zum Beispiel aus einer Polyimidfolie, Kleber, Kupfer, Kleber, Polyimidfolie besteht, ist auf einem Schaltungsträger (LTCC) mit den elektronischen Bauelementen stoffschlüssig verbunden, so zum Beispiel aufgeklebt. Von der LTCC wird direkt auf die flexible Leiterplatte gebondet. Auf die flexible Leiterplatte wiederum wird ein Kunststoffdeckel mit einer eingelegten Elastomerdichtung aufgelegt und so zum Beispiel mittels einer Nietverbindung fest mit der Aluminiumplatte verbunden. Die Wärmeableitung erfolgt hier ebenfalls an das Gehäuse der Getriebehydraulik. Jedoch ist durch den flächigen Aufbau des Steuergerätegehäuses keine erhöhte Fläche notwendig wie bei der Lösung gemäß DE 196 40 466 B4.

DE 10 2004 061 818 A1 bezieht sich auf ein Steuermodul. Bei dieser Lösung wird ein Steuermodul für ein Getriebe eines Kraftfahrzeuges vorgeschlagen, welches ein Trägerteil umfasst. Am Trägerteil ist ein Steuergerät angeordnet, welches ein erstes Gehäuseteil und ein zweites Gehäuseteil und einen zwischen dem ersten Gehäuseteil und dem zweiten Gehäuseteil angeordneten Gehäuseinnenraum aufweist. Es ist wenigstens eine flexible Leiterfolie vorgesehen, welche der elektrischen Verbindung des Schaltungsteiles mit außerhalb des Gehäuseinnenraumes angeordneten elektrischen Bauteilen dient. Das Steuergerät ist mit dem ersten Gehäuseteil an einem Auflagebereich des Trägerteiles aufliegend angeordnet. Das zweite Gehäuseteil ist innerhalb des Auflagebereiches an dem ersten Gehäuseteil angeordnet.

Aus der DE 103 40 974 A1 ist ein Steuergerätegehäuse mit einer Bodenplatte und einem Deckelteil bekannt, wobei auf der Bodenpaltte ein Schaltungsträger mit mindesten einem elektronische Bauelement aufgenommen ist. Die Bodenplatte dient der Wärmableitng und ist mit einem Kusntstoff-Rahmen versehen. Die Bodenplatte und der Kunststoffrahmen bilden eine erstes wannenförmiges Gehäusteteil.

Aus der DE 10 2005 063 280 A1 ist ein Elektornikgehäuse bekannt, das einen als Sockel ausgebildete Trägerplatte umfasst, auf der ein Schaltungsträger angeordnet ist. Die Trägerplatte wird von einem wannförmigen Deckelteil abgedeckt.

Aus der DE 196 40 466 A1 ist ein metallisches Trägerteil für elektronische Bauelemente bekannt, bei dem die elektrischen Anschlüsse von der Bestückungsseite über mehrere in Glasdurchführungen eingeschmolzene Anschlussstifte bis auf eine der Bestücktungsseite gegenüberliegende Seite des Trägerteils hindruchgeführt sind.

### Offenbarung der Erfindung

Der erfindungsgemäß vorgeschlagenen Lösung folgend, wird ein Steuergerätegehäuse bereitgestellt, welches ein metallisches Teil in Gestalt einer wannenförmigen Basisform sowie eines Deckels aufweist, der vorzugsweise aus Stahl gebildet ist, wobei die beiden erwähnten metallischen Teile, d.h. wannenförmige Basisform und Deckel, miteinander stoffschlüssig verbunden werden können, so zum Beispiel miteinander verschweißbar sind. Die Kontaktpins zur elektrischen Kontaktierung werden direkt in die Basisform, d.h. das wannenförmige Bauteil, eingeglast. Die erfindungsgemäß vorgeschlagene Lösung zeichnet sich durch eine hervorragende Ebenheit der Bodenplatte aus. Dadurch entstehen geringe Spalte zwischen dem Schaltungsträger und der Bodenplatte beziehungsweise zwischen der Bodenplatte und dem Getriebehydraulikgehäuse, was wiederum eine gute Wärmeableitung sicherstellt. Die Kontaktstifte werden der erfindungsgemäß vorgeschlagenen Lösung folgend, derart angeordnet, dass ein "Drahtbond" zur Kontaktierung auf die Stirnseite des Kontaktpins gesetzt werden kann. Die erfindungsgemäß vorgeschlagene Lösung bietet ferner die Möglichkeit, über eine Zugentlastung mechanische Kräfte, so zum Beispiel Vibrationen, Schwingungen sowie thermisch bedingte Ausdehnungen, die im Betrieb auftreten können, aufzunehmen, damit die elektrische Kontaktierung von Kontaktpin zu Stanzgitter, die im Rahmen der Laserschweißung als stoffschlüssige Verbindung hergestellt wird, weitestgehend frei von mechanischen Belastungen gehalten werden kann. Des Weiteren hat die erfindungsgemäß vorgeschlagene Lösung den Vorteil, dass diese modulartig in verschiedenen Varianten von Elektronikmodulen und nicht nur an besonders beanspruchten Getrieben oder dergleichen eingesetzt werden kann.

Das Einfügen der die elektrische Kontaktierung sicherstellenden Kontaktpins erfolgt direkt im Wege des Einglasens in die Basisform. Die Verwendung von Werkstoffen wie Metall und Glas sowie das Schweißen als eingesetztes stoffschlüssiges Fügeverfahren beziehungsweise der

Einglasprozess der Kontaktpins ermöglichen die Herstellung eines hermetisch dichten, kostengünstigen Gehäuses mit robusten, bewährten Prozessen.

Insbesondere weist die eingesetzte wannenförmige Basisform eine sehr hohe Struktursteifigkeit auf. Durch diese ist es möglich, die Kontaktpins direkt in die wannenförmige Basisform im Wege des Prozessschrittes Einglasen zu befestigen, ohne dass sich bei diesem Bearbeitungsprozess bei hohen Temperaturen die Bodenfläche der wannenförmigen Basisform in unzulässiger Weise verzieht und deren Maßhaltigkeit Schaden nimmt. Somit kann auf das Einschweißen der Stiftleisten in die Bodenplatte, wie noch gemäß DE 196 40 466 B4 beschrieben, vollständig verzichtet werden. Durch die mit der Wannenform einhergehende Struktursteifigkeit ist keine erhöhte Fläche zur Sicherstellung der Wärmeabfuhr im Wege der Wärmeleitung erforderlich. Die Fläche für die mechanische Fixierung des Getriebesteuerungsmoduls, d.h. die Anschraubfläche, sowie die Fläche, die für die Wärmeabfuhr benötigt wird, stellen eine Ebene dar, so dass das Gehäuse der Getriebehydraulik in einfacher Weise eben ausgeführt werden kann, was dessen Herstellkosten günstig beeinflusst.

Der Rand der im Wesentlichen wannenförmig ausgebildeten Basisform ist derart ausgeführt, dass einzelne Bereiche mit Bohrungen größer als der Deckel sind, der die Basisform abschließt. Der vergrößerte Rand der Basisform bietet die Möglichkeit, Stanzgitter mechanisch am Steuergerätegehäuse zu fixieren, zum Beispiel indem an das Stanzgitter angespritzte Kunststoffzapfen durch die Bohrungen im Rand gesteckt werden und anschließend dort vernietet werden können. Hierdurch wird eine Zugentlastung des Stanzgitters erreicht, so dass die elektrische Kontaktierung zwischen Stanzgitter und Kontaktpin, welche im Wege des Laserschweißens mit dem Basisteil zum Beispiel gefügt werden kann, keinen mechanischen Belastungen ausgesetzt ist. Außerdem lässt sich somit eine leicht handhabbare Baugruppe Steuergerät/Stanzgitter darstellen, was vorteilhaft hinsichtlich der Herstellung ist.

Die mechanische Befestigung des Steuergerätegehäuses erfolgt durch Aufbringen einer senkrecht auf den Deckel wirkenden Kraft. Die senkrecht auf den Deckel wirkende Kraft kann zum Beispiel durch eine Feder realisiert werden. Dies bietet einerseits die Möglichkeit, das Steuergerätegehäuse mechanisch zu fixieren und andererseits über eine dergestalt ausgeführte Anpressung eine optimale Anpressung für die Wärmeabfuhr unter minimaler Ausbildung von Spalten zu erreichen, was insgesamt gesehen den Wärmetransport über Wärmeleitung günstig beeinflusst.

Durch die im Wesentlichen wannenförmige Struktur der Basisform des Steuergerätegehäuses ist es möglich, die eingeglasten stiftförmigen Kontaktpins senkrecht zum Schaltungsträger anzuordnen. Dadurch wird eine vorteilhafte Anordnung für das Vornehmen des Drahtbondens zwischen den eingeglasten Kontaktstiften und dem Schaltungsträger erreicht. Bei so genannten Hybridgehäusen mit waagerecht eingeglasten Kontaktpins würde zwar auch eine ebene Anbindung ermöglicht, hier ist jedoch der Prozessschritt des Bondens sehr ungünstig. Um hier eine Bondverbindung herstellen zu können, müsste in einem zusätzlichen Arbeitsgang eine ebene Fläche angeprägt werden. Die waagerechte Anordnung der Kontaktpins ist zudem ungünstig für das Bonden, da sie zum Schwingen neigt.

In einer weiteren vorteilhaften Ausführungsform des der Erfindung zugrunde liegenden Gedankens wird vorgeschlagen, in die wannenförmige Basisform des Steuergerätegehäuses einen metallischen Block einzubringen, der vorzugsweise aus einem Werkstoff wie zum Beispiel Aluminium besteht. Auf diesen metallischen Block wird der Schaltungsträger aufgeklebt. Der metallische Block wird als Wärmeverteiler eingesetzt und bietet eine bessere Abfuhr der Wärme bei besonders heißen Bauelementen. Zudem ist es möglich, gemäß dieser weiteren Ausführungsform des der Erfindung zugrunde liegenden Gedankens den metallischen Block isoliert zur wannenförmigen Basisform einzukleben und auf diese Weise eine hochwirksame Abschirmung zu erreichen.

### Kurze Beschreibung der Zeichnungen

Anhand der Zeichnung wird die Erfindung nachstehend eingehender beschrieben. Es zeigt:
- Figur 1: eine perspektivische Ansicht mehrerer Stanzgitter am Getriebesteuerungsmodul mit Steuergerätegehäuse,
- Figur 2: eine perspektivische Draufsicht auf ein wannenförmiges Gehäuseteil eines Steuergerätegehäuses und
- Figur 3: einen Schnitt durch das Steuergerätegehäuse im an ein Getriebehydraulikgehäuse angestellten, einen Wärmetransport durch Wärmeleitung ermöglichenden Zustand.

### Ausführungsformen

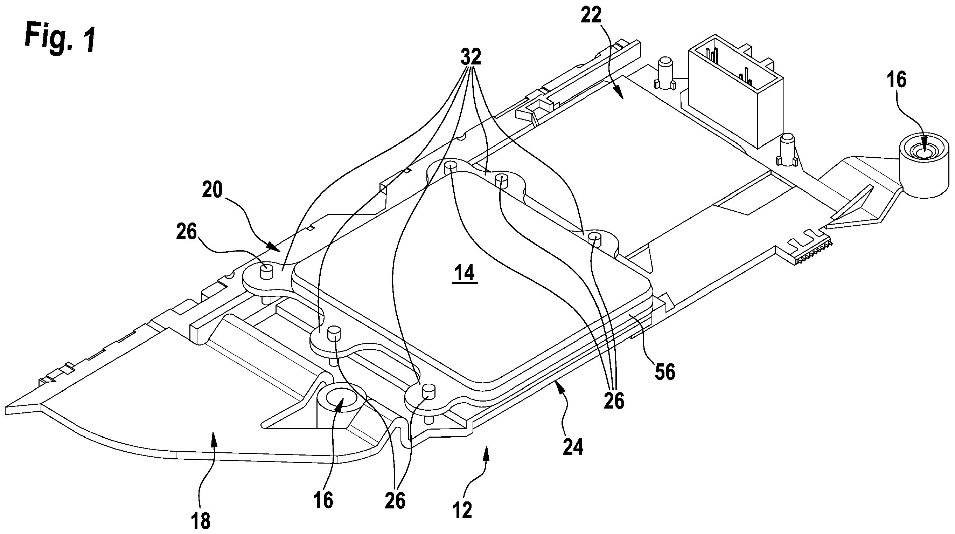

Figur 1 zeigt in perspektivischer Draufsicht die Stanzgitter, die das wannenförmige Gehäuseteil des Steuergerätegehäuses am Getriebesteuerungsmodul umgeben.

Die mechanische Fixierung zwischen Zugentlastungslaschen 32 beziehungsweise der diese durchsetzenden Vernietungen 26 mit Stanzgittern 18, 20 und 22 erfolgt derart, dass die eigentliche elektrische Kontaktierung von durch Einglasungen 38 im Randbereich 34 des wannenförmigen Gehäuseteiles 24 angeordneten Kontaktierungspins 36 entkoppelt ist. In Einglasungen 38, die der Isolation und der Gasdichtheit dienen, aufgenommene Kontaktpins 36 werden senkrecht in Bezug auf einen Randbereich 34 des wannenförmigen Gehäuseteiles 24 angeordnet, was die Ausbildung von Bondverbindungen, insbesondere ein Drahtverbonden, erheblich vereinfacht.

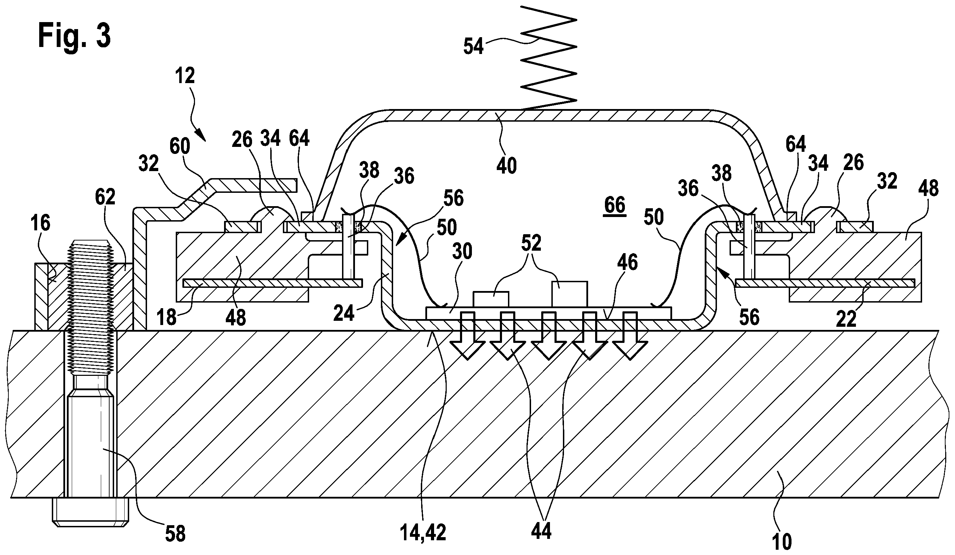

Der Darstellung gemäß Figur 1 ist zu entnehmen, dass das Steuergerätegehäuse 12 am Getriebesteuerungsmodul, insbesondere dessen wannenförmiges Gehäuseteil 24 die Wärmeabfuhrfläche 14 aufweist, die im Wesentlichen als eben verlaufende Planfläche ausgeführt ist. Bezugszeichen 16 bezeichnet einzelne Befestigungsöffnungen zur Befestigung des Steuergerätegehäuses 12 am Getriebesteuerungsmodul, mit denen dieses an einem in Figur 3 schematisch dargestellten Getriebehydraulikgehäuse 10 befestigt werden kann.

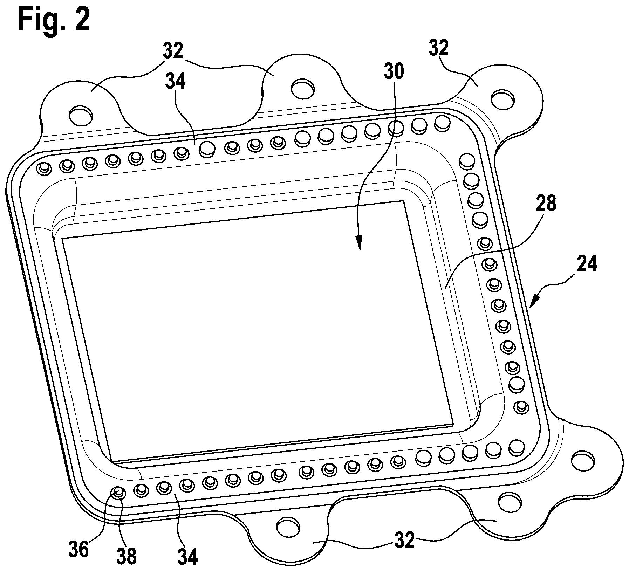

Figur 2 zeigt eine perspektivische Ansicht des wannenförmigen Gehäuseteils mit darin einliegendem Schaltungsträger sowie entlang des Umfangs angeordneten Zugentlastungslaschen.

Figur 2 zeigt, dass das wannenförmige Gehäuseteil 24 eine eben ausgebildete Bodenfläche umfasst, auf welcher ein Schaltungsträger 30 aufliegt. Senkrecht zur Bodenfläche des wannenförmig ausgebildeten Gehäuseteils 24 erstreckt sich eine Seitenwand 56, welche eine Innenseite 28 des wannenförmigen Gehäuseteiles 24 begrenzt. Entlang des Umfangs des wannenförmigen Gehäuseteiles 24 erstreckt sich der Rand 34. Das in Figur 2 in perspektivischer Ansicht dargestellte wannenförmige Gehäuseteil 24 lässt sich als Tiefziehteil aus einem Stahlblech kostengünstig und robust herstellen. Entlang des Randes 34 sind in Einglasungen 38 aufgenommene Kontaktpins 36 angeordnet. Die Kontaktpins 36, die ein stiftförmiges Aussehen haben, erstrecken sich senkrecht, d.h. in einem Winkel von 90° zur ebenen Fläche des Randes 34 des wannenförmigen Gehäuseteiles 24. Die Anordnung der Kontaktpins 36 entlang des Randes 34 des wannenförmigen Gehäuseteiles 24 kann an einer oder mehreren nebeneinander liegenden Stellen oder an einer oder mehreren Seiten entlang des Randes 34 erfolgen. Die Anzahl der in Einglasungen 38 im Rand 34 aufgenommenen Kontaktpins 36 kann entsprechend den Erfordernissen der elektronischen Schaltung am Schaltungsträger 30 variieren. Der Schaltungsträger 30 ist beispielsweise als ein LTCC (low temperature co-fired ceramic) ausgeführt und auf dem Boden des wannenförmigen Gehäuseteiles 24 aufgeklebt. Der Schaltungsträger 30 umfasst die elektronische Schaltung und ist mit mindestens einem elektronischen Bauelement 52 bestückt (siehe auch Schnittdarstellung gemäß Figur 3).

Die Zugentlastungslaschen 32 sind in der Darstellung gemäß Figur 2 in einer Ebene entlang des Randes 34 angeordnet. Die Anordnung der Zugentlastungslaschen 32 ist abhängig von der Position der Stanzgitter 18, 20, 22, mit denen das wannenförmige Gehäuseteil 24 zu befestigen ist.

Figur 3 zeigt eine Schnittdarstellung durch ein Steuergerätegehäuse, dessen Unterseite mit einer Planseite eines Getriebehydraulikgehäuses in die Wärmeleitung begünstigender Weise kontaktiert ist.

Figur 3 zeigt, dass die Wärmeabfuhrfläche 14 des wannenförmigen Gehäuseteiles 24 entlang einer Kontaktfläche 42 zwischen dem wannenförmigen Gehäuseteil 24 insbesondere der Wärmeabfuhrfläche 14 an ein Getriebehydraulikgehäuse 10 angestellt ist. Je größer die Kontaktfläche zwischen der Wärmeabfuhrfläche 14 an der Unterseite des wannenförmigen Gehäuseteiles 24 und der eben ausgeführten Planfläche des Getriebehydraulikgehäuses 10 gestaltet werden kann, eine umso bessere Wärmeableitung 44 stellt sich ein. Figur 3 zeigt des Weiteren, dass im Hohlraum 66, der zwischen dem wannenförmigen Gehäuseteil 24 und dessen Deckelteil 40 gebildet ist, der Schaltungsträger 30 mit mindestens einem elektronischen Bauelement 52 bestückt ist. Die Unterseite des Schaltungsträgers 30 bildet mit der Bodenfläche des wannenförmigen Gehäuseteiles 24 eine Kontaktfläche 46 zwischen Schaltungsträger 30 und dem wannenförmigen Gehäuseteil 24. Auch hier gilt, dass eine Wärmeleitung 44 umso günstiger ist, je größer die Kontaktfläche 46 zwischen dem Schaltungsträger 30 und der Innenseite des Bodens des wannenförmigen Gehäuseteiles 24 gestaltet werden kann. Die Wärmeableitung 44 ist umso besser, je kleiner die verbleibenden Spaltweiten zwischen dem Schaltungsträger 30 und der Oberseite der Wärmeabfuhrfläche 14 beziehungsweise zwischen der Unterseite, d.h. der Wärmeabfuhrfläche 14 des wannenförmigen Gehäuseteiles 24, und der oberen eben ausgeführten Planseite des Getriebehydraulikgehäuses 10 gestaltet werden können.

Der mindestens eine Schaltungsträger 30 nimmt auf seiner Oberseite eine elektronische Schaltung auf, die mindestens ein elektronisches Bauelement 52 umfasst. Das mindestens eine elektronische Bauelement 52 ist zum Schaltungsträger 30 elektrisch kontaktiert und wird vorzugsweise durch Drahtbonden auf den Schaltungsträger 30 aufgeklebt. Der Schaltungsträger 30 selbst ist ebenfalls über Bondverbindungen 50 mit den in den Einglasungen 38 im Rand 34 des wannenförmigen Gehäuseteils 24 stiftförmig ausgebildeten Kontaktpins 36 elektrisch kontaktiert. Wie aus der Schnittdarstellung gemäß Figur 3 hervorgeht, besteht zwischen einer Umspritzung 48 des ersten Stanzgitters 18 und des dritten Stanzgitters 22 und der Mantelfläche des stiftförmig ausgebildeten Kontaktpins 36 Spiel, so dass eine mechanische Entkopplung des stiftförmig ausgebildeten Kontaktpins 36 gegeben ist und dieser lediglich die Stanzgitter 18 beziehungsweise 22 elektrisch kontaktiert. Mechanische Zugbelastungen werden über die Zugentlastungslaschen 32, die Vernietung 26 beziehungsweise die die Stanzgitter 18 und 22 jeweils umgebende Umspritzung 48 aufgenommen. Die Bondverbindung 50 zwischen den Kontaktstiften 36 und dem Schaltungsträger 30 sind so ausgebildet, dass diese nicht mechanisch auf Zug oder Biegung oder dergleichen beansprucht sind.

Das wannenförmige Gehäuseteil 24 ist mittels eines Deckelteils 40 hermetisch dicht verschlossen. Bevorzugt wird eine hermetisch dichte Verbindung zwischen dem wannenförmigen Gehäuseteil 24 und dem Deckelteil 40 entlang eines Dichtrandes 64 durch eine stoffschlüssige Verbindung erzeugt. Diese stellt eine Gasdichtheit des Hohlraumes 66 zwischen dem wannenförmig ausgebildeten Gehäuseteil 24 und dem Deckelteil 40 sicher. Die stoffschlüssige Verbindung entlang des Dichtrandes 64 zwischen dem wannenförmigen Gehäuseteil 24 und dem Deckelteil 40 wird bevorzugt durch Schweißen hergestellt. Ein derartig ausgebildetes Steuergerätegehäuse 12 kann als kleine Baueinheit nunmehr elektrisch geprüft werden. In einer derart vormontierten Baueinheit kann sowohl die Dichtheit des Innenraumes 66 geprüft werden, ferner können Prüfungen bei erhöhter oder erniedrigter Umgebungstemperatur durchgeführt werden, da die Masse und das Bauvolumen des Steuergerätegehäuses 12 klein sind.

Wie aus der Schnittdarstellung aus Figur 3 des Weiteren hervorgeht, ist das einstückig ausgebildete Deckelteil 40 des erfindungsgemäß vorgeschlagenen Steuergerätegehäuses 12 mittels einer Anstellfeder 54 gegen die eben ausgebildete Planfläche des Getriebehydraulikgehäuses 10 gestellt. Aufgrund der eben ausgebildeten Wärmeabfuhrfläche 14 und der eben ausgebildeten Oberseite des Getriebehydraulikgehäuses 10 ist eine optimale Wärmeeinleitung 44 gewährleistet.

Außerhalb des hermetisch abgedichteten Hohlraumes 66 des Steuergerätegehäuses 12 werden die in Einglasungen 38 aufgenommenen Kontaktpins 36 vorzugsweise im Wege des Laserschweißens mit einem oder mehreren Stanzgittern 18, 20, 22 elektrisch kontaktiert. Mit den Stanzgittern 18, 20, 22 sind ein oder mehrere Sensoren beziehungsweise Stecker eines Elektronikmoduls elektrisch kontaktiert. Als Fixierungsmöglichkeiten bieten sich zum Beispiel Gewindebuchsen 62 an, über welche Befestigungselemente 58 wie zum Beispiel Schrauben zur Verschraubung des Steuergerätegehäuses 12 am Getriebehydraulikgehäuse 10 verwendet werden können.

Die Befestigungsöffnungen 16 am Steuergerätegehäuse 12 und die Wärmeabfuhrfläche 14 können zur Verbesserung der thermischen Kontaktierung der Wärmeabführftäche 14 in einer Ebene ausgebildet werden. Dies erlaubt eine einfache und kostengünstige Gestaltung des Steuergerätegehäuses 12 für eine Getriebehydraulik. Des Weiteren kann eine sehr günstige Wärmeableitung 44 realisiert werden, die eine zuverlässige Ableitung der von dem mindestens einen elektronischen Bauelement 52 erzeugten Verlustleistung ermöglicht.

In einer weiteren Ausgestaltung des der Erfindung zugrunde liegenden Gedankens kann in das wannenförmige Gehäuseteil 24 des Steuergerätegehäuses 12 ein metallischer Block eingebracht werden, der vorzugsweise aus Aluminium gefertigt ist. Auf diesen Aluminiumblock kann der Schaltungsträger 30 stoffschlüssig befestigt, so zum Beispiel aufgeklebt werden. Der Aluminiumblock kann in vorteilhafter Weise als Wärmespeicher oder Wärmeverteiler verwendet werden, um eine bessere Abfuhr der Verlustleistung eines zum Beispiel besonders heißen elektronischen Bauelementes 52 zu erreichen. Weiterhin ist es möglich, den Block aus metallischem Material isoliert zum wannenförmigen Gehäuseteil 24 einzubringen, so zum Beispiel einzukleben, und so eine hochwirksame Abschirmung zu erreichen. Je größer der zum Beispiel aus Aluminium gefertigte metallische Block gefertigt wird, eine desto höhere Wärmespeicherkapazität kann erreicht werden.

Die erfindungsgemäß vorgeschlagene, vorstehend anhand der Figuren 1 bis 3 beschriebene Lösung in ihren verschiedenen Ausführungsvarianten ermöglicht die Herstellung einer hermetischen Dichtheit, insbesondere der Gasdichtheit eines Hohlraumes 66 eines Steuergerätegehäuses 12, ein wannenförmiges Gehäuseteil 24 und ein Deckelteil 40 umfassend. Das Steuergerätegehäuse 12 umfasst im Wesentlichen die beiden Gehäuseteile 24 beziehungsweise 40. In das wannenförmige Gehäuseteil 24 sind die Kontaktpins 36 in Einglasungen 38 aufgenommen, wobei das Deckelteil 40 mit dem wannenförmigen Gehäuseteil 24 entlang des Dichtrandes 64 im Wege einer stoffschlüssigen Verbindung, d.h. einem robusten Prozess, wie zum Beispiel Schweißen, hermetisch dicht (gasdicht) verschlossen wird. Das wannenförmige Gehäuseteil 24 und das Deckelteil 40 können kostengünstig als Tiefziehbauteile hergestellt werden. Durch die Wannenform des Gehäuseteiles 24 ist es möglich, den Schaltungsträger 30 beziehungsweise den als Wärmespeicher dienenden metallischen Block an eine eben ausgebildete Planfläche des Getriebehydraulikgehäuses 10 anzustellen, dort zu fixieren und gleichzeitig auch an dieser Fläche die thermische Kontaktierung des Steuergerätegehäuses 12 zu gewährleisten. Der vergrößerte Rand 34 des wannenförmigen Gehäuseteiles 24 bietet die Möglichkeit, die Stanzgitter 18, 20, 22, welche das Steuergerät elektrisch kontaktieren, derart mit dem Steuergerätegehäuse 12 zu verbinden, dass eine mechanische Zugentlastung für die elektrische Kontaktierung 50, 36 durch die Zugentlastungslaschen 32 erreicht werden kann. Die im Wesentlichen stiftförmig ausgebildeten Kontaktpins 36 können in Einglasungen 38 aufgenommen werden, da die Wannenform des Gehäuseteiles 24 eine sehr hohe Struktursteifigkeit aufweist. Dies vermeidet einen Verzug der thermischen Kontaktfläche, d.h. der Kontaktflächen 42 beziehungsweise 46, wie obenstehend beschrieben.

Des Weiteren kann durch die erfindungsgemäß vorgeschlagene Lösung, insbesondere durch die wannenförmige Ausgestaltung des Gehäuseteils 24 des Steuergerätegehäuses 12 erreicht werden, dass eine senkrechte Anordnung der stiftförmig ausgebildeten Kontaktpins 36 erfolgt, was eine vorteilhafte schwingungsarme Drahtbondung ermöglicht. Die kompakte Gestaltung des erfindungsgemäß vorgeschlagenen Steuergerätegehäuses 12 ermöglicht zudem eine einfache Funktionsprüfung auch bei höheren Temperaturen sowie eine extrem einfache Handhabung. Das im Wesentlichen als modulare Einheit ausgebildete Steuergerätegehäuse 12 kann auch als Steuergerät in anderen Applikationen als der obenstehenden Getriebeapplikation eingesetzt werden.

## Patentansprüche

1. Steuergerätegehäuse (12), insbesondere für ein Getriebesteuerungsmodul eines Getriebes eines Kraftfahrzeugs mit einem ersten Gehäuseteil (24) und einem zweiten, ein Deckelteil (40) bildenden Gehäuseteil (40), wobei im ersten Gehäuseteil (24) ein Schaltungsträger (30) mit mindestens einem elektronischen Bauelement (52) aufgenommen ist und das erste Gehäuseteil (24) in Form einer Wanne (28) ausgeführt ist, deren Boden als Wärmeabfuhrfläche (14) zur Kontaktierung eines weiteren Gehäuses (10) ausgeführt ist, wobei das erste Gehäuseteil (24) einen umlaufenden Rand (34) aufweist, in dem stiftförmige Kontaktelemente (36) in Einglasungen (38) aufgenommen sind, und wobei die stiftförmigen Kontaktelemente (36) senkrecht im Rand (34) eingeglast sind **gekennzeichnet dadurch, dass** die stiftförmigen Kontaktelemente (36) eine elektrische Kontaktierung zu mindestens einem Stanzgitter (18, 20, 22) aufweisen und dass das erste Gehäuseteil (24) an einem umlaufenden Rand (34) eine Anzahl von Laschen (32) zur Aufnahme mechanischer Beanspruchungen aufweist, an denen eine Befestigung, insbesondere eine Vernietung (26), zu einer die Stanzgitter (18, 20,22) jeweils umgebenden Umspritzung (48) ausgeführt ist, wobei die Befestigung, insbesondere die Vernietung (26), die elektrische Kontaktierung zwischen dem mindestens einen Stanzgitter (18, 20, 22) und den stiftförmigen Kontaktelementen (36) von mechanischen Beanspruchungen entlastet.

2. Steuergerätegehäuse gemäß Anspruch 1, **dadurch gekennzeichnet, dass** das erste Gehäuseteil (24) und das zweite als Deckelteil (40) vorgesehene Gehäuseteil (40) stoffschlüssig miteinander gefügt sind, wobei die stoffschlüssige Verbindung eine Abdichtung (64) bildet.

3. Steuergerätegehäuse gemäß Anspruch 1, **dadurch gekennzeichnet, dass** der Schaltungsträger (30) eine Wärmeableitung (44) ermöglichende Kontaktfläche (46) bildend im ersten Gehäuseteil (24) aufgenommen ist, oder auf einem in den ersten Gehäuseteil (24) aufgenommenen Block aus metallischem Material aufgebracht ist.

4. Steuergerätegehäuse gemäß Anspruch 1, **dadurch gekennzeichnet, dass** eine Kontaktfläche (42) zwischen der Wärmeabfuhrfläche (14) an der Unterseite des ersten Gehäuseteiles (24) und einem weiteren Gehäuse (10) in einer Ebene liegt, in der eine Befestigung (16, 58, 62) des Getriebesteuerungsmoduls erfolgt.

5. Steuergerätegehäuse gemäß Anspruch 1, **dadurch gekennzeichnet, dass** der Schaltungsträger (30) und/oder das mindestens eine elektronische Bauelement (52) mit den elektrischen Kontaktelementen (36) über Bondverbindungen (50) elektrisch kontaktiert ist.

6. Steuergerätegehäuse gemäß Anspruch 1, **dadurch gekennzeichnet, dass** dieses über eine zusätzliche Anstellfeder (54) mit der Wärmeabfuhrfläche (14) an das weitere Gehäuse (10) zur Reduzierung einer Spaltweite entlang der Kontaktfläche (42) angestellt ist.

7. Steuergerätegehäuse gemäß Anspruch 3, **dadurch gekennzeichnet, dass** der Block aus metallischem Material im ersten Gehäuseteil (24) elektrisch isoliert ist.

## Claims

1. Control unit housing (12), in particular for a transmission control module of a transmission of a motor vehicle, comprising a first housing part (24) and a second housing part (40), forming a cover part (40), wherein a circuit carrier (30) with at least one electronic component (52) is accommodated in the first housing part (24) and the first housing part (24) is designed in the shape of a tub (28), the bottom of which is designed as a heat dissipation area (14) for contacting a further housing (10), wherein the first housing part (24) has a peripheral edge (34), in which pin-shaped contact elements (36) are accommodated in glazed mounts (38), and wherein the pin-shaped contact elements (36) are glazed in perpendicularly in the edge (34), **characterized in that** the pin-shaped contact elements (36) have electrical contacting in relation to at least one lead frame (18, 20, 22) and **in that** the first housing part (24) has at a peripheral edge (34) a number of lugs (32) for absorbing mechanical stresses, at which a fastening, in particular a riveting (26), to an encapsulation (48) respectively surrounding the lead frames (18, 20, 22) is provided, wherein the fastening, in particular the riveting (26), relieves the electrical contacting between the at least one lead frame (18, 20, 22) and the pin-shaped contact elements (36) of mechanical stresses.

2. Control unit housing according to Claim 1, **characterized in that** the first housing part (24) and the second housing part (40), provided as a cover part (40), are joined to one another with a form fit, the form-fitting connection forming a sealing (64).

3. Control unit housing according to Claim 1, **characterized in that** the circuit carrier (30) is accommodated in the first housing part (24) forming a contact area (46) that makes heat dissipation (44) possible, or is applied to a block of metallic material that is accommodated in the first housing part (24).

4. Control unit housing according to Claim 1, **characterized in that** a contact area (42) between the heat dissipation area (14) on the underside of the first housing part (24) and a further housing (10) lies in a plane in which a fastening (16, 58, 62) of the transmission control module takes place.

5. Control unit housing according to Claim 1, **characterized in that** the circuit carrier (30) and/or the at least one electronic component (52) is/are electrically contacted in relation to the electrical contact elements (36) by way of bonding connections (50).

6. Control unit housing according to Claim 1, **characterized in that**, by means of an additional adjusting spring (54), it is placed with the heat dissipation area (14) against the further housing (10) to reduce a gap width along the contact area (42).

7. Control unit housing according to Claim 3, **characterized in that** the block of metallic material in the first housing part (24) is electrically insulated.

## Revendications

1. Carter d'appareil de commande (12), notamment destiné à un module de commande de boîte de vitesses d'une boîte de vitesses d'un véhicule automobile, comportant une première partie de carter (24) et une deuxième partie de carter (40) formant une partie de recouvrement (40), dans lequel un support de circuit (30) comportant au moins un composant électronique (52) est reçu dans la première partie de carter (24), et la première partie de carter (24) est réalisée sous la forme d'une cuve (28) dont le fond est réalisé sous la forme d'une surface de dissipation thermique (14) destinée à être mise en contact avec un autre carter (10), dans lequel
la première partie de carter (24) comporte un bord circonférentiel (34) dans lequel des éléments de contact en forme de broches (36) sont reçus dans des vitrifications (38), et dans lequel les éléments de contact en forme de broches (36) sont vitrifiés perpendiculairement dans le bord (34), **caractérisé en ce que** les éléments de contact en forme de broches (36) comportent une mise en contact électrique avec au moins une grille estampée (18, 20, 22) et **en ce que** la première partie de carter (24) comporte sur un bord périphérique (34) un certain nombre de languettes (32) destinées à recevoir des contraintes mécaniques, sur lesquelles est réalisée une fixation, notamment un rivetage (26) sur une encapsulation (48) enveloppant respectivement les grilles estampées (18, 20, 22), dans lequel la fixation, notamment le rivetage (26), élimine la charge imposée par les contraintes mécaniques sur la mise en contact électrique entre l'au moins une grille estampée (18, 20, 22) et les éléments de contact en forme de broches (36).

2. Carter d'appareil de commande selon la revendication 1, **caractérisé en ce que** la première partie de carter (24) et la deuxième partie de carter (40) prévue en tant que partie de recouvrement (40) sont emboîtées l'une dans l'autre par complémentarité de matériau, dans lequel la liaison par complémentarité de matériau forme un dispositif d'étanchéité (64).

3. Carter d'appareil de commande selon la revendication 1, **caractérisé en ce que** le support de circuit (30) est reçu dans la première partie de carter (24) en formant une surface de contact (46) permettant une dissipation thermique (44) ou est monté sur un bloc constitué de matériau métallique reçu dans la première partie de carter (24).

4. Carter d'appareil de commande selon la revendication 1, **caractérisé en ce qu'**une surface de contact (42) entre la surface de dissipation thermique (14) sur la face inférieure de la première partie de carter (24) et un autre carter (10) se situe dans un plan dans lequel s'effectue une fixation (16, 58, 62) du module de commande de boîte de vitesses.

5. Carter d'appareil de commande selon la revendication 1, **caractérisé en ce que** le support de circuit (30) et/ou l'au moins un composant électronique (52) est mis en contact électrique avec les éléments de contact électriques (36) par l'intermédiaire de liaisons par soudure (50).

6. Carter d'appareil de commande selon la revendication 1, **caractérisé en ce qu'**il est utilisé par l'intermédiaire d'un ressort de réglage (54) supplémentaire muni de la surface de dissipation thermique (14) sur l'autre carter (10) afin de réduire une largeur d'interstice le long de la surface de contact (42).

7. Carter d'appareil de commande selon la revendication 3, **caractérisé en ce que** le bloc constitué de matériau métallique est électriquement isolé dans la première partie de carter (24).
